# EUROPÄISCHE PATENTSCHRIFT

(11) **EP 2 577 341 B1**
(45) Veröffentlichungstag und Bekanntmachung des Hinweises auf die Patenterteilung: **19.12.2018**
(21) Anmeldenummer: 11729365.4
(22) Anmeldetag: 30.05.2011
(51) Int. Cl.: G01R 33/44

(54) **FIELD-CYCLING NMR RELAXOMETRIE**
FIELD CYCLING NMR RELAXOMETRY
RELAXOMÉTRIE PAR RMN À CYCLAGE DE CHAMP

(30) Priorität: 01.06.2010 DE 102010022385
(43) Veröffentlichungstag der Anmeldung: 10.04.2013
(73) Patentinhaber: FUJARA, Marian, 22926 Ahrensburg (DE)
(72) Erfinder: FUJARA, Franz, 64367 Mühltal (DE); FUJARA, Marian, 22926 Ahrensburg (DE); GÄDKE, Achim, 6021 Wellington (NZ); PRIVALOV, Alexei, 64319 Pfungstadt (DE)
(74) Vertreter: Isfort, Olaf
(86) Internationale Anmeldenummer: PCT/EP2011/002662
(87) Internationale Veröffentlichungsnummer: WO 2011/151049

(56) Entgegenhaltungen:
- ROMMEL E ET AL: "A powerful NMR field-cycling device using GTOs and MOSFETs for relaxation dispersion and zero-field studies", JOURNAL OF MAGNETIC RESONANCE, ACADEMIC PRESS, LONDON, GB, Bd. 70, Nr. 2, 1. November 1986 (1986-11-01), Seiten 219-234, XP023956762, ISSN: 0022-2364, DOI: 10.1016/0022-2364(86)90004-1 [gefunden am 1986-11-01]
- G.S.WATERS ET AL.: "A nuclear magnetometer", J.SCI.INSTRUM., Bd. 35, 1958, Seiten 88-93, XP000002658296,
- E.ANOARDO ET AL.: "Magnetic Field Compensation for Field-Cycling NMR Relaxometry in the ULF Band", APPL.MAGN.RESON., Bd. 24, 2003, Seiten 85-96, XP000002658297,
- VADIM S ZOTEV ET AL: "SQUID-Based Microtesla MRI for In Vivo Relaxometry of the Human Brain", IEEE TRANSACTIONS ON APPLIED SUPERCONDUCTIVITY, IEEE SERVICE CENTER, LOS ALAMITOS, CA, US, Bd. 19, Nr. 3, 1. Juni 2009 (2009-06-01), Seiten 823-826, XP011261915, ISSN: 1051-8223
- A.N.MATLACHOV ET AL.: "SQUID detected NMR in microtesla magnetic fields", JOURNAL OF MAGNETIC RESONANCE, Bd. 170, 2004, Seiten 1-7, XP000002658298,
- CARLSON J W ET AL: "MR relaxometry imaging. Work in progress", RADIOLOGY, RADIOLOGICAL SOCIETY OF NORTH AMERICA, OAK BROOK,IL, US, Bd. 184, Nr. 3, 1. September 1992 (1992-09-01), Seiten 635-639, XP007909560, ISSN: 0033-8419

## Beschreibung

Die Erfindung betrifft ein Kernspinrelaxometrieverfahren gemäß dem Oberbegriff von Anspruch 1.

Field-Cycling NMR (Nuclear Magnetic Resonance) Relaxometrie ist ein bekanntes Verfahren, mittels welchem Messungen der Magnetfeld (B₀-Feld) abhängigen longitudinalen (Spin-Gitter) Relaxationszeit (T₁) über einen Feldstärkenbereich von über sechs Dekaden, d.h. zwischen 10⁻⁶ T bis ungefähr 1 T, durchgeführt werden können. Dabei ist es von besonderem Interesse, in möglichst kleinen Magnetfeldern Kernspinrelaxation zu messen, um Informationen beispielsweise über langsame dynamische Prozesse in interessierenden Proben zu erhalten.

Langsame dynamische Prozesse weisen nur eine sehr ineffiziente Kopplung an das Spin-Gitter-Relaxationsverhalten von Kernspins in hohen statischen Magnetfeldern (>0.1 T) auf, wie sie z.B. zu Zwecken der Kernspin-Spektroskopie typischerweise verwendet werden, so dass es erforderlich ist, bei entsprechend großen Korrelationszeiten der interessierenden dynamischen Prozesse, entsprechende Kernspin-Relaxationsmessungen bei besonders niedrigen Magnetfeldstärken durchzuführen.

Um jedoch die dabei auftretende Problematik zu umgehen, dass bei niedrigen Magnetfeldstärken lediglich eine minimale Kernspin-Polarisation vorliegt, wird die Technik der Field-Cycling NMR Relaxometrie angewandt. Einen guten Überblick über Field-Cycling NMR Relaxometrie gibt beispielsweise die Publikation von Kimmich et al., Progress in Nuclear Magnetic Resonance Spectroscopy 44 (2004), 257 - 320.

Das Grundprinzip der Kernspin-Relaxometrie besteht darin, dass zunächst das Kernspinsystem einer Probe mittels eines Polarisationsmagnetfelds vorpolarisiert wird. Anschließend wird dieses Polarisationsmagnetfeld schnell auf einen definierten anderen Wert (Evolutionsmagnetfeld) umgeschaltet. Die Kernspin-Polarisation relaxiert nun auf den in diesem Evolutionsmagnetfeld herrschenden thermischen Gleichgewichtswert. Nach der (variablen) Evolutionszeit wird auf ein Detektionsmagnetfeld umgeschaltet, in dem mittels geeigneter Hochfrequenzimpulse die momentane Kernspin-Polarisation als Funktion der Evolutionszeit gemessen wird. Aus dieser Abhängigkeit kann dann direkt die Spin-Gitter-Relaxationszeit (longitudinale Relaxationszeit) in dem gewählten Evolutionsmagnetfeld bestimmt werden.

Ein Anwendungsbereich der Field-Cycling NMR Relaxometrie ist die Untersuchung lokaler Bewegungen, beispielsweise in kondensierten Phasen. Dabei wird der Dynamikbereich zwischen der NMR Linienformspektroskopie und der NMR Austauschspektroskopie auf der einen Seite (langsame Prozesse) und der quasi elastischen Neutronenstreuung auf der anderen Seite (schnelle Prozesse) abgedeckt. Möglich ist es jedoch auch, die Field-Cycling Relaxometrie mit der NMR Diffusometrie zu kombinieren und so Informationen über Prozesse auf einer mikroskopischen Skala mit solchen auf einer mesoskopischen Skala in Verbindung zu bringen. Damit bedient das Verfahren ein breites praktisches Anwendungsspektrum, wofür hier drei Beispiele genannt seien:
a) Bei der Untersuchung der Ionendynamik in Systemen, die für Brennstoffzellen und moderne Akkumulatoren relevant sind, können mit diesen Verfahren die Primärprozesse identifiziert werden.
b) Langsame Polymerbewegungen, die beispielsweise den Alterungsmechanismus und das mechanische Verhalten von modernen synthetischen Verbundwerkstoffen bestimmen, können gezielt analysiert werden.
c) Ebenso spiegelt die Relaxationsdispersion in charakteristischer Weise Struktur-Dynamik-Beziehungen in Soft-Matter-Systemen (zum Beispiel in Membranen, kolloidalen Lösungen und Suspensionen, Mikroemulsionen und Flüssigkristallen) wieder.

Bei der Weiterentwicklung der Kernspin-Relaxometrie zu niedrigsten Magnetfeldern, insbesondere weit unterhalb des Erdmagnetfelds, ist eine exakte Messung des während der Evolutionszeit vorliegenden Magnetfeldvektors für den Messvorgang von entscheidender Bedeutung. Bekannt hierfür sind beispielsweise Magnetfeldmessungen zeitgleich zum Relaxometrie-Experiment, indem Sonden in der Nachbarschaft der Probe positioniert werden. Allerdings ist insbesondere bei ultrakleinen Magnetfeldern (kleiner als 10 % des Erdmagnetfelds) dadurch keine hinreichend genaue Magnetfeldmessung gewährleistet.

Eine Alternative dazu besteht in der Möglichkeit, eine separate Kalibrierung der Zusatzspule durchzuführen. Dieses Verfahren ist jedoch nicht geeignet, um ausreichend genau definierte Magnetfelder deutlich unterhalb des Erdmagnetfelds einzustellen.

Rommel et al. (Journal of Magnetic Resonance 70, 219-234, 1986) beschreiben ein leistungsstarkes Field-Cycling NMR Spektrometer, das auf der Basis von Halbleiterschaltern arbeitet und ein besonders schnelles Umschalten des Magnetfeldes ermöglicht. Beschrieben wird die Anwendung des Spektrometers u.a. für Nullfeld-Messungen, bei denen das Magnetfeld von einer höheren Polarisationsfeldstärke auf ein sehr niedriges Detektionsmagnetfeld umgeschaltet wird, wo NMR Spektren beobachtet werden können, die z.B. vom Erdmagnetfeld bestimmt sind.

Waters et al. (Journal of Scientific Instruments 35, 88-93, 1958) beschreiben ein NMR Magnetometer, das sich zur Messung des Erdmagnetfeldes eignet. Davon ausgehend liegt der Erfindung die Aufgabe zugrunde, ein verbessertes Kernspinrelaxometrieverfahren zu schaffen.

Die der Erfindung zugrunde liegende Aufgabe wird durch ein Kernspinrelaxometrieverfahren nach Anspruch 1 gelöst.

Es wird ein Kernspin-Relaxometrie-Verfahren geschaffen, mittels welchem die Bestimmung des longitudinalen Relaxationsverhaltens von Kernspins einer Probe bestimmt werden kann:
a) Das Verfahren umfasst dabei zunächst den Schritt des Aussetzens der Probe einem statischen Polarisationsmagnetfeld zur Sättigungspolarisierung der Kernspins, wobei das Polarisationsmagnetfeld eine Polarisationsfeldstärke und eine vorgegebene Polarisationsmagnetfeldrichtung aufweist, so dass die Magnetisierung der Kernspins in z-Richtung weist;
b) In einem weiteren Schritt erfolgt die Veränderung der Polarisationsfeldstärke zu einer Evolutionsfeldstärke durch Aussetzen der Probe einem statischen Evolutionsmagnetfeld, wobei die Veränderung der Polarisationsfeldstärke zu der Evolutionsfeldstärke nichtadiabatisch erfolgt, wobei die Probe der Evolutionsfeldstärke über einen vorgegebenen Evolutionszeitraum ausgesetzt wird, wobei das Evolutionsmagnetfeld eine vorgegebene Evolutionsmagnetfeldrichtung aufweist und die Evolutionsfeldstärke niedriger ist als die Polarisationsfeldstärke. Ferner unterscheidet sich die Evolutionsmagnetfeldrichtung von der Polarisationsmagnetfeldrichtung.
c) Es folgt nun das Aussetzen der Probe einem statischen Detektionsmagnetfeld und die Messung der z-Komponente der Magnetisierung der Kernspins im Detektionsmagnetfeld, wobei das Detektionsmagnetfeld eine Detektionsfeldstärke und eine vorgegebene Detektionsmagnetfeldrichtung aufweist, wobei die Detektionsfeldstärke größer ist als die Evolutionsfeldstärke. Die Messung der Magnetisierung der Kernspins erfolgt durch eine Auslese-Pulssequenz.
d) Schließlich werden die vorigen Schritte für verschiedene Evolutionszeiträume wiederholt und das longitudinale Relaxationsverhalten der Kernspins und die Evolutionsfeldstärke werden aus der gemessenen z-Komponente der Magnetisierung in Abhängigkeit von der jeweiligen Dauer der verschiedenen Evolutionszeiträume bestimmt.

Entscheidend ist hierbei, dass sich die Evolutionsmagnetfeldrichtung von der Polarisationsmagnetfeldrichtung unterscheidet. Hierdurch wird eine gedämpfte Präzession der Kernspinmagnetisierung um die Achse des Evolutionsmagnetfeldes mit der der Stärke des Evolutionsmagnetfeldes entsprechenden Larmor-Frequenz gezielt herbeigeführt. Diese Präzession wird gleichzeitig mit der Kernspin-Gitter-Relaxationszeit gemessen. Da hierbei dieselben Kernspins sowohl die Larmor-Präzession als auch die Spin-Gitter-Relaxation vollführen, wird eine Zuordnung der gemessenen Relaxationszeit bzw. der Relaxationszeitenverteilung zu einer Magnetfeldstärke des Evolutionsmagnetfelds unter Ausschluss aller systematischen Fehlerquellen möglich. Damit ist die Größe der Magnetfelder des Evolutionsmagnetfelds bis hinab zu Bruchteilen eines Mikrotesla (µT) messbar. Die Messung der Feldstärke wird perfekt in-situ, d.h. durch die untersuchten Kernspins selbst durchgeführt.

Gemäss der Erfindung erfolgt die Veränderung der Polarisationsfeldstärke zu der Evolutionsfeldstärke nichtadiabatisch schnell. Das bedeutet, dass während des Umschaltens des Magnetfeldes von der Polarisationsfeldstärke auf die Evolutionsfeldstärke kein thermischer Austausch des Kernspinsystems mit der Umgebung (dem Gitter) stattfindet, wobei keine Richtungsänderung des Magnetisierungsvektors der Kernspins beim Umschalten des Magnetfeldes stattfindet. Dies ermöglicht es, die gemessene Kernspin-Relaxation tatsächlich dem Evolutionsfeld zuzuordnen.

Nach einer weiteren Ausführungsform der Erfindung wird das Polarisationsmagnetfeld durch eine erste Magnetanordnung und das Evolutionsmagnetfeld durch eine zweite Magnetanordnung erzeugt, wobei die räumliche Position der Probe während der Durchführung des Verfahrens relativ zur ersten und zweiten Magnetanordnung zeitlich konstant ist. In anderen Worten wird die Veränderung der Polarisationsfeldstärke zu der Evolutionsfeldstärke lediglich durch ein Schalten der entsprechenden Magnetanordnungen bewirkt, wobei die Probe selbst während der Messung nicht bewegt wird. Dies hat den Vorteil, dass in reproduzierbarer Weise Relaxationsmessungen durchgeführt werden können, ohne der Gefahr ausgesetzt zu sein, dass aufgrund mechanischer Ungenauigkeiten bei einer Probenbewegung eine Verfälschung der Messergebnisse auftritt. Bei der ersten und der zweiten Magnetanordnung kann es sich auch um ein und dieselbe Anordnung handelt, die zur Erzeugung des Polarisationsfeldes bzw. des Evolutionsfeldes entsprechend unterschiedlich bestromt wird.

In einer alternativen Ausführungsform wird die Veränderung der Polarisationsfeldstärke zur Evolutionsfeldstärke durch eine relative Bewegung von Probe, Polarisationsmagnetfeld und Evolutionsmagnetfeld bewirkt (mechanisches Field Cycling). Beispielsweise wird die Probe räumlich vom Polarisationsmagnetfeld in das Evolutionsmagnetfeld bewegt. Ein Vorteil hier ist, dass die Probe ohne technisch aufwendiges Schalten von Elektromagneten unterschiedlichen Magnetfeldern ausgesetzt werden kann. Z.B. bleibt eine Restmagnetisierung nach Veränderung des Magnetfelds von der Polarisationsfeldstärke zur Evolutionsmagnetfeldstärke in diesem Fall unbeachtlich.

Gemäß der Erfindung erfolgt die Messung der Feldstärke simultan mit dem Relaxometrie-Experiment. Damit ist gewährleistet, dass die Relaxometriedaten eindeutig dem im Zeitpunkt der Relaxometriemessung vorherrschenden Evolutionsmagnetfeld zugeordnet werden können. Eine zeitliche Variation aufgrund beispielsweise von Temperaturschwankungen und/oder Magnetfeldstärkeschwankungen bleibt damit unbeachtlich. Außerdem kann die Gesamtmesszeit bei einer solchen Vorgehensweise reduziert werden.

Bei dem erfindungsgemäßen Verfahren beschreibt die gemessene Polarisation in Abhängigkeit von der Evolutionszeit eine gedämpfte Oszillationskurve, wobei die Bestimmung der Evolutionsfeldstärke eine Bestimmung des Kurvenverlaufs der gedämpften Oszillationskurve, und zwar die Bestimmung der Oszillationsfrequenz umfasst.

Die bei dem erfindungsgemäßen Verfahren erhaltene Messkurve (Polarisation als Funktion der Evolutionszeit) weist einen oszillierenden Anteil auf und zeigt außerdem einen exponentiellen Verlauf der Polarisation mit zunehmender Evolutionszeit entsprechend der longitudinalen Relaxation. Die Oszillationsfrequenz der besagten Oszillationskurve entspricht dabei der Larmor-Frequenz der Kernspins, mit welcher die Kernspins am Probenort aufgrund des Evolutionsmagnetfelds präzedieren. Damit lassen sich aus der besagten Oszillationskurve unmittelbar die Larmor-Frequenz und damit die Magnetfeldstärke des Evolutionsmagnetfelds bestimmen.

Nach einer weiteren Ausführungsform der Erfindung ist die Polarisationsfeldstärke gleich der Detektionsfeldstärke und die Polarisationsmagnetfeldrichtung gleich der Detektionsmagnetfeldrichtung. Es sei jedoch darauf verwiesen, dass die Verwendung einer Polarisationsfeldstärke gleich der Detektionsfeldstärke lediglich eine optionale Möglichkeit des besagten Kernspin-Relaxometrie-Verfahren ist. Hier sind grundsätzlich auch durchaus unterschiedliche Feldstärken möglich. Allerdings vereinfacht die Wahl der Polarisationsfeldstärke gleich der Detektionsfeldstärke weiter die Bestimmung des Evolutionsmagnetfelds und auch des Relaxationsverhaltens der Kernspins. Außerdem ermöglicht dies in technisch einfacher Weise, eine entsprechende Kernspin-Relaxometrie-Vorrichtung zur Bestimmung des longitudinalen Relaxationsverhaltens der Kernspins bereitzustellen.

Nach einer weiteren Ausführungsform der Erfindung erfolgt die Messung der Polarisation der Kernspins der Probe über einen Radiofrequenz-Auslesepuls und einen anschließenden freien Induktionsverfall oder über eine geeignete Auslese-Pulssequenz (z.B. Spin-Echo oder CPMG). In beiden Fällen weist die resultierende von der Evolutionszeit abhängige Polarisation der Kernspins ein einfach zu analysierendes und charakteristisches Verhalten in Form eines exponentiellen Verlaufs in Kombination mit einer Oszillation auf.

Im Folgenden werden bevorzugte Ausführungsformen der Erfindung anhand der Zeichnungen näher erläutert. Es zeigen:
- Figur 1: den Zeitverlauf einer Präzessionsmessung eines NMR Field-Cycling Relaxometrieverfahrens.
- Figur 2: eine Messung der Evolutionszeit abhängigen Magnetisierung von Kernspins,
- Figur 3: eine Messung der Evolutionszeit abhängigen Magnetisierung von Kernspins,
- Figur 4: ein Beispiel einer simultanen Messung des Evolutionsmagnetfeldes und des Magnetisierungsabfalls,
- Figur 5: eine schematische Ansicht einer Kernspin-Relaxometrie- Vorrichtung.

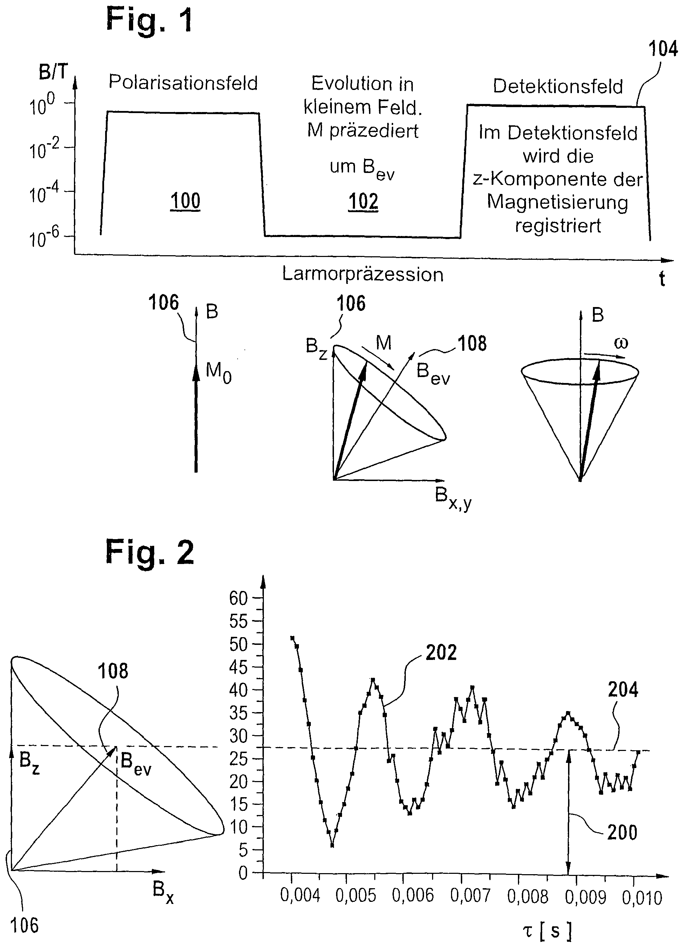

Die Figur 1 illustriert den Zeitverlauf eines Field-Cycling NMR Relaxometrie-Experiments. Das Verfahren beginnt mit der Vorpolarisation von Kernspins einer Probe in einem großen Magnetfeld, dem sogenannten Polarisationsmagnetfeld. Dieses Polarisationsmagnetfeld hat dabei eine Größenordnung von bis zu einem Tesla.

Nachdem die Kernspinmagnetisierung nach einem Zeitraum 100 einen Sättigungszustand erreicht hat, erfolgt ein hinreichend (nichtadiabatisch) schnelles Umschalten des Magnetfelds zu einem kleinen, in seiner Ausrichtung einstellbaren Evolutionsmagnetfeld derart, dass die Kernspins nicht folgen können. Beispielsweise war die Polarisationsmagnetfeldrichtung des Polarisationsmagnetfelds die B_{z}-Richtung 106, sodass die Magnetisierung der Kernspins ebenfalls in Richtung 106 weist.

Aufgrund einer gegenüber der Polarisationsmagnetfeldrichtung 106 verkippten Evolutionsmagnetfeldrichtung 108 beginnen die Kernspins in dem Evolutionsmagnetfeld Bₑᵥ eine Larmor-Präzession um den Vektor Bₑᵥ auszuführen. Dies erfolgt während der Evolutionszeitraumes 102. Während des Evolutionszeitraums 102 findet auch eine Relaxation der Magnetisierung in Richtung einer neuen Gleichgewichtsmagnetisierung statt.

Am Ende des Evolutionszeitraums 102 findet wiederum ein Umschalten des Magnetfelds auf ein Detektionsmagnetfeld statt, wobei im Detektionsmagnetfeld über einen Zeitraum 104 die z-Komponente der Magnetisierung registriert wird. Die Registrierung der z-Komponente der Magnetisierung erfolgt beispielsweise über einen Radiofrequenz-Auslesepuls und einen freien Induktionszerfall oder über eine Spin-Echo-Pulssequenz während des Zeitraums 104.

Zusammengefasst lässt sich somit das in Figur 1 gezeigte Verfahren so erläutern, dass das Polarisationsmagnetfeld nichtadiabatisch zu einem dazu verkippten Evolutionsmagnetfeld heruntergeschaltet wird, wobei die Beobachtung der (aufgrund von transversaler Relaxation, T₂, T₂*) gedämpften Präzession um die Richtung des Evolutionsmagnetfeldes Bₑᵥ und des relaxationsbedingten Abfalls der Magnetisierung im Evolutionsmagnetfeld anhand des Kernspinsignals in dem Detektionsmagnetfeld nach Einstrahlung beispielsweise eines 90°-Hochfrequenzpulses als Funktion des Evolutionszeitraumes 102 erfolgt.

Beispielhafte Messungen des Magnetisierungszerfalls, der über den Evolutionszeitraum 102 stattfindet, seien nun im Folgenden in Bezug auf die Figuren 2 - 4 erläutert.

Die Figur 2 zeigt das Messergebnis einer ¹H NMR-Messung in einer wässrigen CuSO₄-Lösung. Die Richtung des Polarisationsfeldes liegt dabei in Richtung 106 (z-Richtung), wohingegen die Richtung des Evolutionsmagnetfeldes in Richtung 108 liegt, d.h. um ca. 45° gekippt in Bezug auf die z-Richtung. Im Evolutionsmagnetfeld führt dies zu einer Präzession der Magnetisierung M um Bₑᵥ. Die Detektion der z-Komponente der Magnetisierung im Detektionsmagnetfeld in Abhängigkeit von der Evolutionszeitdauer τ ergibt eine Signaloszillation 202, welche annähernd symmetrisch um eine Mittellinie 204 oszilliert. Die Bestimmung der Oszillationsfrequenz, der Amplitudenverhältnisse und des Versatzes 200 der Mittellinie 204 relativ zur Basislinie der Oszillationskurve ermöglicht die vollständige Bestimmung des Evolutionsmagnetfelds.

In Figur 2 ergibt die Analyse der Oszillation eine Präzessionsfrequenz von ca. 900 Hz, entsprechend einer Feldamplitude von ca. 21 µT. Wie Abbildung 2 belegt, sind auf diese Weise Magnetfelder, die ¹H NMR-Frequenzen bis hinab zu wenigen 100 Hz entsprechen, direkt messbar.

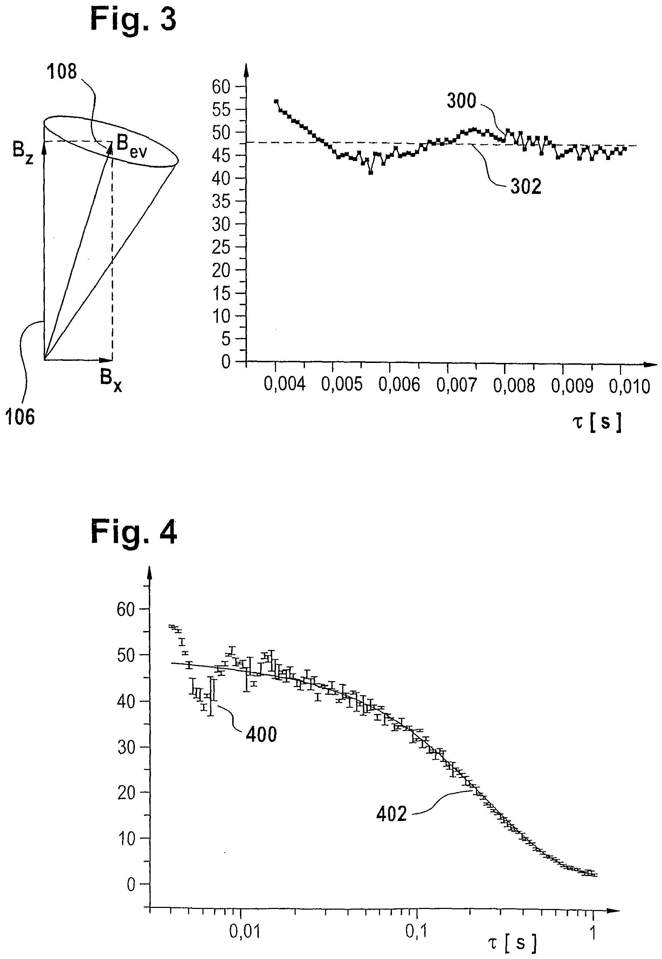

Die Figur 3 zeigt ein weiteres Beispiel einer ¹H NMR-Messung in einer wässrigen CuSO₄-Lösung. Im Unterschied zu Figur 2 liegt in der Figur 3 die Richtung des Evolutionsmagnetfelds 108 in der Nähe der Z-Achse, d.h. die Evolutionsmagnetfeldrichtung unterscheidet sich nur gering von der Polarisationsmagnetfeldrichtung 106. Als Ergebnis ergibt sich ein Oszillationsverhalten 300 der Magnetisierung in Abhängigkeit von dem Evolutionszeitraum 102, wobei die Oszillationsamplitude der Oszillation 300 nur geringfügig um einen Mittelwert 302 schwankt.

Durch erneute Analyse der Amplitudenverhältnisse, des Mittelwerts 302, der Lage der Amplituden zum Nullpunkt und der Frequenz der Oszillationskurve 300 kann wiederum das Oszillationsfeld vollständig bestimmt werden. In der Figur 3 liegt die Präzessionsfrequenz bei lediglich 200 Hz, wobei die z-Komponente des Evolutionsfeldes ca. 5 µT und die x-Komponente 1 - 2 µT beträgt.

Die in Figur 4 gezeigte Messung demonstriert die Vorgehensweise bei einer simultanen Messung des Evolutionsmagnetfeldes und der Spin-Gitter-Relaxationszeit: Ein zur z-Achse schwach verkipptes Evolutionsmagnetfeld wird nichtadiabatisch schnell angefahren. Die Kernspins präzedieren darin mit ihrer Larmor-Frequenz und liefern damit die gewünschte Information über die Evolutionsfeldstärke. Die Präzession entspricht dabei der Oszillation 400 der Magnetisierungskurve. Die Oszillation 400 ist aufgrund der transversalen Relaxation gedämpft.

Eine weitere Zerfallskomponente 402 der Magnetisierung liefert die Spin-Gitter-Relaxationszeit T₁ in dem Evolutionsfeld. In der Figur 4 ergibt sich die Evolutionsmagnetfeldstärke aus der gemessenen ¹H Larmor-Frequenz von 200 Hz (siehe auch Figur 3) und die Spin-Gitter-Relaxationszeit zu T₁ = 0,22 (3) Sekunden.

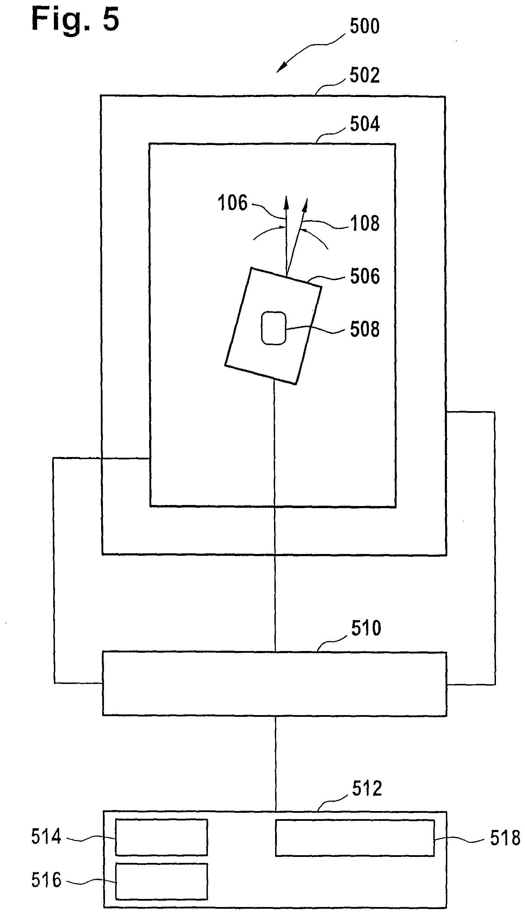

Die Figur 5 zeigt eine schematische Ansicht einer Kernspin-Relaxometrie-Vorrichtung, eines sogenannten Field-Cycling NMR Relaxometers. Die Vorrichtung 500, welche eine simultane Messung des Evolutionsmagnetfeldes erlaubt, besteht aus einer schnell schaltbaren Hauptspule 504, einer ebenfalls schnell schaltbaren Hilfsspule 506 sowie schnell schaltbaren Korrekturspulen z.B. für die x-, y- und z-Richtung. Diese Korrekturspulen sind in der Figur 5 allgemein mit dem Bezugszeichen 502 gekennzeichnet und umfassen beispielsweise Helmholtz-Spulenpaare.

Die Korrekturspulen 502 dienen zunächst zur Kompensierung von Streumagnetfeldern und den Erdmagnetfeldern am Ort der Probe 508. Die Spule 504 dient in diesem Beispiel sowohl zur Erzeugung des Polarisationsmagnetfeldes als auch des Detektionsmagnetfeldes in Richtung 106. In der Figur 5 wird dabei davon ausgegangen, dass das Detektionsmagnetfeld mit dem Polarisationsmagnetfeld identisch ist.

Den Korrekturspulen 502 kommt jedoch noch eine weitere Aufgabe zu: Das benötigte verkippte Evolutionsmagnetfeld in Richtung 108 wird in der Ausführungsform der Fig. 5 durch die drei Korrekturspulen 502 erzeugt, wobei die Zusatzspule 506 benötigt wird, um beim schnellen Herunterschalten der Hauptspule 504 durch kurzzeitiges Anlegen eines Zusatzfeldes Nulldurchgänge des Magnetfelds durch Magnetfeld-Überschwinger zu verhindern. Außerdem können kleine z-Magnetfelder dadurch gut realisiert werden.

Die Spulen 506, 504 und 502 werden über ein entsprechendes Netzteil 510 mit elektrischer Energie in gewünschter Weise versorgt. Die Steuerung des Netzteils und damit der Spulen 502, 504 und 506 erfolgt über ein Datenverarbeitungssystem 512, welches hierzu einen Prozessor 514 und einen Speicher 516 aufweist. Der Speicher 516 weist dabei durch den Prozessor 514 ausführbare Instruktionen zur Durchführung des erfindungsgemäßen Verfahrens auf. Ein Interface 518 des Datenverarbeitungssystems 512 dient zur Übermittlung von Steuersignalen an das Netzteil 510.

Das in Figur 5 gezeigte Field-Cycling Relaxometer ermöglicht die Bestimmung der Magnetfeldstärke des Evolutionsmagnetfelds 506 am Probenort 508 in-situ durch die untersuchten Kernspins der Probe 508 selbst. Die Messung der Feldstärke erfolgt dabei simultan mit dem Relaxometrie-Experiment, wobei die Größe der Magnetfelder bis zu Bruchteilen eines Mikrotesla messbar ist.

### Bezugszeichenliste

- 100: Zeitraum
- 102: Zeitraum
- 104: Zeitraum
- 106: Magnetfeldrichtung
- 108: Evolutionsmagnetfeldrichtung
- 200: Versatz
- 202: Oszillation
- 204: Mittelwert
- 300: Oszillation
- 302: Mittelwert
- 400: Oszillation
- 402: Relaxationskomponente
- 500: Relaxometrievorrichtung
- 502: Korrekturspulen
- 504: Spule
- 506: Spule
- 508: Probe
- 510: Netzteil
- 512: Datenverarbeitungssystem
- 514: Prozessor
- 516: Speicher
- 518: Interface

## Patentansprüche

1. Kernspinrelaxometrieverfahren zur Bestimmung des longitudinalen Relaxationverhaltens von Kernspins einer Probe mit den folgenden Schritten:
- Aussetzen der Probe einem statischen Polarisationsmagnetfeld zur Sättigungspolarisierung der Kernspins, wobei das Polarisationsmagnetfeld eine Polarisationsfeldstärke und eine vorgegebene Polarisationsmagnetfeldrichtung (106) aufweist, so dass die Magnetisierung der Kernspins in z-Richtung weist;
- Veränderung der Polarisationsfeldstärke zu einer Evolutionsfeldstärke durch Aussetzen der Probe einem statischen Evolutionsmagnetfeld, wobei die Veränderung der Polarisationsfeldstärke zu der Evolutionsfeldstärke nichtadiabatisch erfolgt, wobei die Probe der Evolutionsfeldstärke über einen vorgegebenen Evolutionszeitraum (102) ausgesetzt wird, wobei das Evolutionsmagnetfeld eine vorgegebene Evolutionsmagnetfeldrichtung (108) aufweist, wobei die Evolutionsfeldstärke niedriger ist als die Polarisationsfeldstärke,
- Aussetzen der Probe einem statischen Detektionsmagnetfeld und Messung der z-Komponente der Magnetisierung der Kernspins im Detektionsmagnetfeld, wobei das Detektionsmagnetfeld eine Detektionsfeldstärke und ein vorgegebene Detektionsmagnetfeldrichtung aufweist, wobei die Detektionsfeldstärke größer ist als die Evolutionsfeldstärke, wobei die Messung der Magnetisierung der Kernspins durch eine Auslese-Pulssequenz erfolgt,
- Wiederholen der vorigen Schritte für verschiedene Evolutionszeiträume und Bestimmung des longitudinalen Relaxationverhaltens der Kernspins aus der gemessenen z-Komponente der Magnetisierung in Abhängigkeit von der jeweiligen Dauer der verschiedenen Evolutionszeiträume,
**dadurch gekennzeichnet, dass** die Evolutionsmagnetfeldrichtung (108) sich von der Polarisationsmagnetfeldrichtung (106) unterscheidet, wobei auch die Evolutionsfeldstärke aus der gemessenen z-Komponente der Magnetisierung in Abhängigkeit von der jeweiligen Dauer der verschiedenen Evolutionszeiträume bestimmt wird, wobei die gemessene z-Komponente der Magnetisierung in Abhängigkeit von der jeweiligen Dauer der verschiedenen Evolutionszeiträume eine gedämpfte Oszillationskurve (202; 300; 400) beschreibt, wobei die Bestimmung der Evolutionsfeldstärke eine Bestimmung der Oszillationsfrequenz der Oszillationskurve (202; 300; 400) umfasst.

2. Verfahren nach einem der vorigen Ansprüche, wobei das Polarisationsmagnetfeld durch eine erste Magnetanordnung und das Evolutionsmagnetfeld durch eine zweite Magnetanordnung erzeugt wird, wobei die räumliche Position der Probe während der Durchführung des Verfahrens relativ zur ersten und zweiten Magnetanordnung zeitlich konstant ist.

3. Verfahren nach einem der vorigen Ansprüche, wobei die Veränderung der Polarisationsfeldstärke zur Evolutionsfeldstärke durch eine Bewegung der Probe relativ zu Polarisationsmagnetfeld und Evolutionsmagnetfeld bewirkt wird.

4. Verfahren nach einem der vorigen Ansprüche, wobei die Polarisationsfeldstärke gleich der Detektionsfeldstärke und die Polarisationsmagnetfeldrichtung (106) gleich der Detektionsmagnetfeldrichtung ist.

5. Verfahren nach einem der vorigen Ansprüche, wobei die Messung der Polarisation der Kernspins der Probe über einen Radiofrequenz-Auslesepuls und einen freien Induktionszerfall erfolgt.

## Claims

1. Nuclear magnetic resonance relaxometry method for determining the longitudinal relaxation behaviour of nuclear spins of a sample, having the following steps:
- exposing a sample to a static polarization magnetic field for saturation polarization of the nuclear spins, wherein the polarization magnetic field has a polarization field strength and a specified polarization magnetic field direction (106), such that the magnetization of the nuclear spins points in the z-direction;
- changing the polarization field strength to an evolution field strength by exposing the sample to a static evolution magnetic field, wherein the change in the polarization field strength to the evolution field strength is effected non-adiabatically, wherein the sample is exposed to the evolution field strength over a specified evolution time period (102), wherein the evolution magnetic field has a specified evolution magnetic field direction (108), wherein the evolution field strength is lower than the polarization field strengths,
- exposing the sample to a static detection magnetic field and measuring the z-component of the magnetization of the nuclear spins in the detection magnetic field, wherein the detection magnetic field has a detection field strength and a specified detection magnetic field direction, wherein the detection field strength is greater than the evolution field strength, wherein the measurement of the magnetization of the nuclear spins is effected by way of a readout pulse sequence,
- repeating the preceding steps for different evolution time periods and determining the longitudinal relaxation behaviour of the nuclear spins from the measured z-component of the magnetization in dependence on the duration of the respective different evolution time periods,
**characterized in that** the evolution magnetic field direction (108) differs from the polarization magnetic field direction (106), wherein the evolution field strength is also determined from the measured z-component of the magnetization in dependence on the respective duration of the different evolution time periods, wherein the measured z-component of the magnetization in dependence on the respective duration of the different evolution time periods describes a damped oscillation curve (202; 300; 400), wherein determining the evolution field strength comprises determining the oscillation frequency of the oscillation curve (202; 300; 400).

2. Method according to one of the preceding claims, wherein the polarization magnetic field is produced by a first magnet arrangement and the evolution magnetic field is produced by a second magnet arrangement, wherein the spatial position of the sample during the performance of the method relative to the first and second magnet arrangements is constant over time.

3. Method according to one of the preceding claims, wherein the change in the polarization field strength to the evolution field strength is brought about by a movement of the sample relative to the polarization magnetic field and evolution magnetic field.

4. Method according to one of the preceding claims, wherein the polarization field strength is identical to the detection field strength and the polarization magnetic field direction (106) is identical to the detection magnetic field direction.

5. Method according to one of the preceding claims, wherein the measurement of the polarization of the nuclear spins of the sample is effected via a radiofrequency readout pulse and a free induction decay.

## Revendications

1. Procédé de relaxométrie de spin nucléaire pour la détermination du comportement de relaxation longitudinale de spins nucléaires d'un échantillon, comprenant les étapes suivantes :
- exposer l'échantillon à un champ magnétique de polarisation statique pour la polarisation de saturation des spins nucléaires, dans lequel le champ magnétique de polarisation présente une intensité de champ de polarisation et une direction de champ magnétique de polarisation (106) prédéterminée de sorte que la polarisation des spins nucléaires est dirigée dans la direction z ;
- modifier l'intensité du champ de polarisation pour obtenir une intensité de champ d'évolution en exposant l'échantillon à un champ magnétique d'évolution statique, dans lequel la modification de l'intensité du champ de polarisation pour obtenir l'intensité du champ d'évolution s'effectue de manière non adiabatique, dans lequel l'échantillon est exposé à l'intensité du champ d'évolution au cours d'une période d'évolution prédéterminée (102), dans lequel le champ magnétique d'évolution présente une direction de champ magnétique d'évolution (108) prédéterminée, dans lequel l'intensité du champ d'évolution est inférieure à l'intensité du champ de polarisation,
- exposer l'échantillon à un champ magnétique de détection statique et mesurer la composante z de la magnétisation des spins nucléaires dans le champ magnétique de détection, dans lequel le champ magnétique de détection présente une intensité de champ de détection et une direction de champ magnétique de détection prédéterminée, dans lequel l'intensité du champ de détection est supérieure à l'intensité du champ d'évolution, dans lequel la mesure de la magnétisation des spins nucléaires est effectuée par une séquence d'impulsions de lecture,
- répéter les étapes précédentes pour différentes périodes d'évolution et déterminer le comportement de relaxation longitudinale des spins nucléaires à partir de la composante z mesurée de la magnétisation en fonction de la durée respective des différentes périodes d'évolution,
**caractérisé en ce que** la direction du champ magnétique d'évolution (108) est différente de la direction du champ magnétique de polarisation (106), dans lequel l'intensité du champ d'évolution est également déterminée à partir de la composante z mesurée de la magnétisation en fonction de la durée respective des différentes périodes d'évolution, dans lequel la composante z mesurée de la magnétisation décrit une courbe d'oscillation amortie (202 ; 300 ; 400) en fonction de la durée respective des différentes périodes d'évolution, dans lequel la détermination de l'intensité du champ d'évolution comprend une détermination de la fréquence d'oscillation de la courbe d'oscillation (202 ; 300 ; 400).

2. Procédé selon l'une des revendications précédentes, dans lequel le champ magnétique de polarisation est généré par un premier dispositif magnétique et le champ magnétique d'évolution est généré par un deuxième dispositif magnétique, dans lequel la position spatiale de l'échantillon est constante dans le temps pendant l'exécution du procédé par rapport aux premier et deuxième dispositifs magnétiques.

3. Procédé selon l'une des revendications précédentes, dans lequel la modification de l'intensité du champ de polarisation pour obtenir l'intensité du champ d'évolution est provoquée par un mouvement de l'échantillon par rapport au champ magnétique de polarisation et au champ magnétique d'évolution.

4. Procédé selon l'une des revendications précédentes, dans lequel l'intensité du champ de polarisation est égale à l'intensité du champ de détection et la direction du champ magnétique de polarisation (106) est identique à la direction du champ magnétique de détection.

5. Procédé selon l'une des revendications précédentes, dans lequel la mesure de la polarisation des spins nucléaires de l'échantillon est effectuée par l'intermédiaire d'une impulsion de lecture radiofréquence et d'une désintégration par induction libre.
